Europäisches Patentamt

European Patent Office

Office européen des brevets

(19)

(11) EP 1 548 501 A2

(12) **EUROPEAN PATENT APPLICATION**

(43) Date of publication:
29.06.2005 Bulletin 2005/26

(51) Int Cl.7: **G03F 7/20**, H01S 3/00

(21) Application number: 04030471.9

(22) Date of filing: 22.12.2004

| | |
|---|---|
| (84) Designated Contracting States:<br>**AT BE BG CH CY CZ DE DK EE ES FI FR GB GR HU IE IS IT LI LT LU MC NL PL PT RO SE SI SK TR**<br>Designated Extension States:<br>**AL BA HR LV MK YU** | (72) Inventors:<br>• **Sukegawa, Takashi**<br>  Tokyo (JP)<br>• **Takahashi, Kazuhiro**<br>  Tokyo (JP) |
| (30) Priority: **26.12.2003 JP 2003434733** | (74) Representative:<br>**Leson, Thomas Johannes Alois, Dipl.-Ing.**<br>**Tiedtke-Bühling-Kinne & Partner GbR,**<br>**TBK-Patent,**<br>**Bavariaring 4**<br>**80336 München (DE)** |
| (71) Applicant: **CANON KABUSHIKI KAISHA**<br>**Tokyo (JP)** | |

(54) **Laser unit, exposure apparatus for micro-lithiographie and associated method**

(57) A laser unit for a micro-lithographic exposure apparatus, said laser unit oscillating said laser presenting a first wavelength spectrum, said laser also including a wavelength selector for determining said first wavelength spectrum, and a drive mechanism for changing the first wavelength spectrum at a predetermined period.

FIG. 1

EP 1 548 501 A2

**Description**

The present invention relates generally to a laser unit, an exposure apparatus and method using the same as a light source, and a device manufacturing method.

A projection optical system has conventionally been used to transfer a pattern on a mask (or a reticle) onto a wafer etc. via a projection optical system. Along with recent demands for the finer processing to the semiconductor device, the high-resolution and high-quality exposure have increasingly demanded. As one means for implementing the high resolution, use of the exposure light having a shorter wavelength is promoted: An exposure light source is transited from the KrF laser (with a wavelength of about 248 nm) to the ArF laser (with a wavelength of about 193 nm), and the practical implementation of the $F_2$ laser (with a wavelength of about 157 nm) is now reviewed.

The laser has a spread or a spectrum around a predetermined wavelength, and the excessively wide spectrum causes the chromatic aberration and prevents the high-quality exposure. Thus, the band of the laser's wavelength spectrum has conventionally been narrowed for reduced chromatic aberration (or maintained contrast). Usually, the exposure is optimized to a center wavelength and a spectral bandwidth of the exposure light, and the critical dimension ("CD") of the resolvable pattern is designed to maintain the intended or permissible CD if the exposure light's spectrum is within a range of the spectral bandwidth. On the other hand, the current light-source manufactures' efforts maintain the narrowed spectral bandwidth much smaller than the optimized spectral bandwidth. In other words, even if the narrowed spectral bandwidth is slightly widened, it is still within an optimization range of the exposure apparatus.

Japanese Patent Applications, Publication Nos. 2001-307997, 2003-204104, 2000-332322, 2001-144355, 11-121879, etc. disclose means for narrowing or changing the wavelength of the laser that oscillates from the laser oscillator (or a light source unit).

The high-quality exposure requires not only narrowing of the spectral bandwidth but also the non-fluctuation or stability of the spectral bandwidth during the exposure. However, prior art does not control the fluctuation of the spectral bandwidth, and ignores the influence. However, as the CD becomes smaller with the higher resolution, the permissible variable width for the exposure apparatus gradually reduces and is no longer a negligible factor. The spectral bandwidth varies gradually not instantly. Even when the spectral bandwidth is within an optimization range, when the variance exceeds the permissible range of the exposure apparatus, for example, when the CD for the line and space ("L&S") pattern is different from the CD for the isolated pattern, the demand for the high-quality exposure cannot be met. In addition, a reduction of the variance of the spectral bandwidth down to a certain level would advantageously enlarge the depth of focus ("DOF"), improving the degree of freedom of the process.

Accordingly, it is an exemplary object of the present invention to provide a laser unit, and an exposure method and apparatus using the same, and a device manufacturing method, for the stable spectral bandwidth and the high-quality exposure.

A laser unit according to one aspect of the present invention for oscillating a laser of a first wavelength spectrum includes a wavelength selector for determining a first wavelength spectrum, and a drive mechanism for changing the first wavelength spectrum at a predetermined period.

The drive mechanism may drive said wavelength selector at the predetermined period. The drive mechanism may drive the wavelength selector and a wavelength spectrum that is integrated at the predetermined period of the laser varies at the predetermined period. When a second wavelength spectrum is defined as a wavelength spectrum integrated at the predetermined period of the laser by driving the wavelength selector, a half width of the second wavelength spectrum may be wider than a half width of the first wavelength spectrum. Alternatively, a width of a wave range which 95 % of laser enters in the second wavelength spectrum may be wider than a width of a wave range which 95 % of laser enters in the first wavelength spectrum. The "width of a wave range which 95 % of laser enters in the first (second) wavelength spectrum" includes a value of a center of the first (second) spectrum (or an average value), and corresponds to 2W1 (twice as large as W1), when Wav is defined as the value of the center (or the average value), and W1 is set so that 95 % of the laser is included in a symmetrical range with respect to a wavelength of the value of the center, i.e., between Wav - W1 and Wav + W1.

An exposure apparatus according to another aspect of the present invention for relatively scanning a pattern on a mask and an object, and for exposing the pattern onto the object, includes an illumination optical system for illuminating the pattern using a laser beam from the above laser unit. A time period for which the laser beam may be irradiated onto one point on the object is substantially an integer multiple of the predetermined period. Preferably, (n-0.1)T2 < T1 < (n+0.1)T2 is met, where n is an integer, T1 is a time period for which the laser beam is irradiated onto one point on the object, and T2 is the predetermined time period.

A laser unit according to another aspect of the present invention for outputting a laser beam of a first wavelength spectrum that includes a center wavelength and varies within a first variable width, includes a wavelength selector for determining the center wavelength and the first wavelength spectrum, and a driving unit for driving the wavelength selector and oscillating the laser beam, the laser beam integrated during oscillations includes a center wavelength that is equal or close to the center wavelength of the first wavelength spectrum, and a second wavelength spectrum that varies within a second variable width smaller than the first variable width and is wider than the first wavelength spectrum. The driving unit may include a piezoelectric element.

An exposure apparatus according to another aspect of the present invention includes the above laser unit, and a projection optical system for projecting a pattern on a mask onto an object using the laser beam emitted from the laser unit as exposure light.

An exposure method according to another aspect of the present invention for projecting a pattern on a mask onto an object to be exposed, by using a laser beam as exposure light, the laser beam including a center wavelength and a first spectrum and varies within a first variable width, includes the steps of oscillating the laser beam so that the laser beam integrated during oscillations includes a center wavelength that is equal or close to the center wavelength of the first variable width, and a second wavelength spectrum that varies within a second variable width smaller than the first variable width and is wider than the first wavelength spectrum, and controlling a period of the oscillating step to a period of a projection of the pattern onto the object. The exposure method may use an exposure apparatus for projecting the pattern onto the object, and for optimizing the second wavelength spectrum around the center wavelength. The pattern may include different types of first and second patterns that have the same size and are formed on the mask, wherein the exposure apparatus resolves the first and second patterns when using an integral laser beam having the second variable width, but resolves only one of the first and second patterns when using a laser beam having the first variable width.

An exposure method according to another aspect of the present invention for projecting a pattern on a mask onto an object via a projection optical system using exposure light, and for controlling a resolved size of the pattern projected onto the object, includes the steps of controlling an effective spectral bandwidth of a laser beam that includes a center wavelength and a first wavelength spectrum, and varies within a first variable width.

The controlling step may include oscillating the laser beam so that the laser beam integrated during oscillations includes a center wavelength that is equal or close to the center wavelength of the first wavelength spectrum, and a second wavelength spectrum that varies within a second variable width smaller than the first variable width and is wider than the first wavelength spectrum, and calculating the second wavelength spectrum from a performance of the projection optical system. The pattern may include different types of first and second patterns that have the same size and are formed on the mask, wherein the performance includes a relationship between a difference of a critical dimension of the first and second patterns, and a spectral bandwidth with respect to the center wavelength. Alternatively, the controlling step may change resolvable critical dimensions between the first and second patterns projected onto the object.

A device manufacturing method according to another aspect of the present invention includes the steps of exposing an object using the exposure apparatus, and developing an object that has been exposed. Claims for a device fabricating method for performing operations similar to that of the above exposure apparatus cover devices as intermediate and final products. Such devices include semiconductor chips like an LSI and VLSI, CCDs, LCDs, magnetic sensors, thin film magnetic heads, and the like.

Other objects and further features of the present invention will become readily apparent from the following description of the preferred embodiments with reference to the accompanying drawings.

FIG. 1 is a schematic block diagram of an exposure apparatus according to one embodiment of the present invention.
FIG. 2 is a schematic block diagram of a laser unit in the exposure apparatus shown in FIG. 1.
FIG. 3 is a view for explaining a change of a wavelength spectrum by the laser unit shown in FIG. 2.
FIG. 4 is a flowchart for explaining an exposure method using a spectral bandwidth stabilizing method.
FIG. 5 is a waveform diagram for explaining setting of the oscillatory period.
FIG. 6 is a graph for explaining setting of the wavelength spectral bandwidth shown in FIG. 3.
FIG. 7 is a graph showing a relationship between a spectral bandwidth and a pattern's critical dimension.
FIG. 8 is a flowchart for explaining a method for fabricating devices (semiconductor chips such as ICs, LSIs, and the like, LCDs, CCDs, etc.).
FIG. 9 is a detailed flowchart for Step 4 of wafer process shown in FIG. 8.

Referring now to the accompanying drawings, a description will be given of an exposure apparatus 100 according to the present invention. 1 denotes an exposure apparatus body of a stepper or a step-and-repeat type. Alternatively, the exposure apparatus body 1 may be a scanner or a step-and-scan type. 2 denotes a laser light source that uses an inert gas halide excimer laser (or a so-called excimer laser) as one example of the laser unit, such as a KrF excimer laser (with a wavelength of 248 nm) and an ArF excimer laser (with a wavelength of 193 nm).

The exposure apparatus body 1 includes, along an optical path of the laser beam from the laser unit 2, a beam shaping optical system 3 that shapes a section of a laser beam from the light source 2 into a desired shape, a variable ND filter 4 that adjusts the light intensity of the laser beam, an optical integrator 5 that splits the laser beam and overlaps the split laser beams in order to make the uniform intensity on a reticle 12's surface, a condenser lens 6 that condenses the laser beam via the optical integrator 5, a beam splitter 7 that introduces part of the laser beam from the condenser lens 6 to an photodetector, a masking blade 9 that is arranged near the condensing position of the laser beam by the condenser lens 6 and restricts an irradiation range of the laser beam on the reticle 12 surface, an imaging lens 10 that images an image of the masking blade 9 onto the reticle 12, and a mirror 11 that deflects the direction of the laser beam's optical path toward the projection lens 13.

The laser beam from the laser unit 2, which has passed the illumination optical system including the above elements, illuminates the reticle 12, and a pattern on the reticle 12 is exposed or transferred onto one of plural shots on the semiconductor wafer 14 as a substrate via the projection lens as the projection optical system at a reduction ratio of 1/2 to 1/10. The wafer 14 is moved two-dimensionally along the surface perpendicular to the optical axis of the projection lens 13 by a moving stage (not shown). Whenever the exposure ends for a predetermined short area, a shot area is moved to the next shot area, by the projection lens 13, to which the reticle 12's pattern is to be projected.

15 denotes a barometer that measures the atmospheric pressure in the exposure apparatus at predetermined time intervals. The measured value is sent to the main controller 16 in the exposure apparatus body 1. The main controller 16 calculates an optimal oscillatory wavelength at that time, and sends a wavelength command value to the laser unit 2 at a predetermined timing, such as a timing prior to the exposure of the next shot area after the exposure to a certain shot area ends. The main controller 16 sends a trigger signal for emitting the laser unit 2, and performs a photoelectric conversion signal processing in accordance with the light intensity of the laser beam that has been photoelectrically converted by a photodetector 8. The laser unit 2 controls a unit in the laser unit based on the signals of the wavelength command value and the exposure dose control.

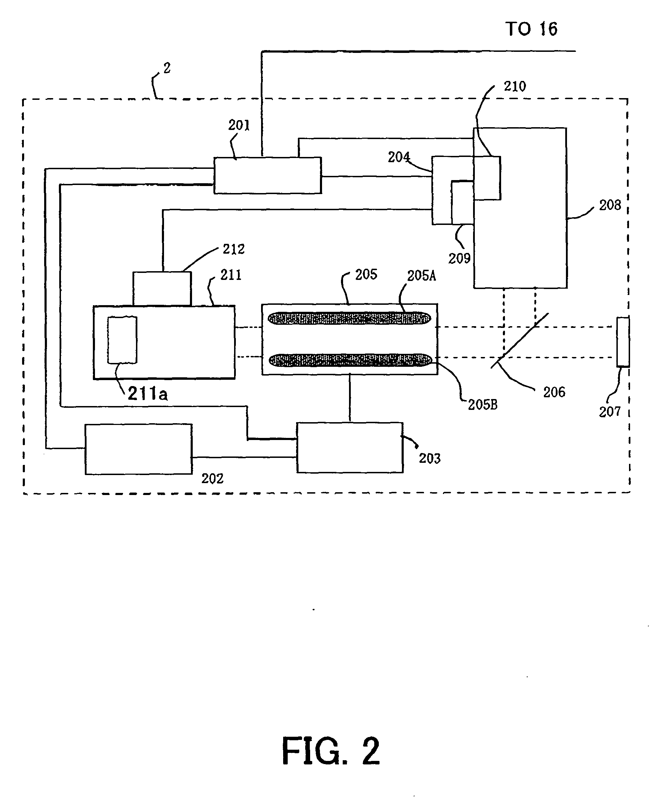

FIG. 2 is a schematic block diagram of the laser unit 2. A laser controller 201 receives the signals of the wavelength command value and the exposure dose control, etc. The laser controller 201 sends a high-voltage signal to a high-voltage power source 202, and a trigger signal to a compression circuit 203 at a laser emitting timing. The laser controller 201 sends the signal of the wavelength command value to a wavelength controller 204.

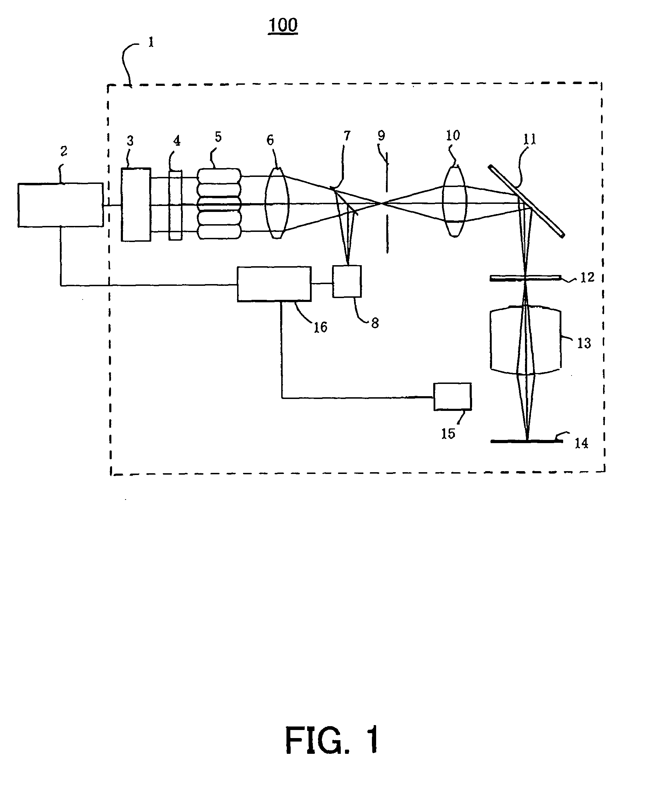

Discharge electrodes 205A, 205B are provided in a laser chamber 205, and discharge in response to the high voltage of about 10 to 30 kV applied by the compression circuit 203. Then, the laser gas sealed in the laser chamber 205 is excited and the laser beam oscillates. A light emitting part of the laser chamber 205 passes a beam splitter 206, and enters the beam shaping optical system 3 shown in FIG. 1 through the shutter 207. Part of the laser beam is reflected on the beam splitter 206, and introduced into an optical monitoring part 208. The laser controller 201 opens and closes a shutter 207 in accordance with a command from the main controller 16 shown in FIG. 1.

The optical monitoring part 208 always monitors the pulsed energy and oscillatory wavelength of the laser beam, and determines whether the measured pulsed energy is within a predetermined range around a target value. When the pulsed energy is lower than a desired value, the laser controller 201 increases the applied voltage to the discharge electrodes 205A and 205B. When the pulsed energy is higher than the desired value, the laser controller 201 decreases the applied voltage to them.

A wavelength controller 204 compares a wavelength command value sent from the laser controller 201 with the wavelength measured by the optical monitoring part 208, and determines whether the measured wavelength is within the predetermined range that centers on the wavelength command value. The optical monitoring part 208 includes an internal environment measuring means 210, such as a barometer and a thermometer, for measuring the environment in the optical monitoring part 208. The internal environment measuring means 210 can measure the refractive index of the air inside the optical monitoring part 208.

A band-narrowing module 211 constitutes a laser resonator with an output mirror (not shown) at the light exit part in the laser chamber 205, and narrows a full width at half maximum of the spectral bandwidth of the laser beam down to about 0.5 pm. The band-narrowing module 211 drives an associative stepping motor 212, and drives (or oscillates) the wavelength selector 211a, such as a grating or etalon, in the band-narrowing module 211. A driving unit of the wavelength selector 211a may use a piezoelectric element.

The wavelength controller 204 compares the wavelength command value sent from the laser controller 201 with the wavelength value measured by the optical monitoring part 208, sends a signal to the stepping motor 212 so that the wavelength of the laser beam falls within the permissible range (or the optimization range of the wavelength by the exposure apparatus), and always controls the wavelength. Moreover, when the spectral bandwidth measured by the optical monitoring part 208 is thinner than a set value, the target value is periodically moved so as to scatter the spectral bandwidth according to the difference, and adjusts the effective spectral bandwidth to the target value. The period is adjusted to the exposure dose control period in the exposure apparatus, i.e., a pattern projecting period. When the target value of the oscillatory wavelength is changed, the wavelength controller 204 drives and adjusts the stepping motor so that the oscillatory wavelength accords with the target wavelength.

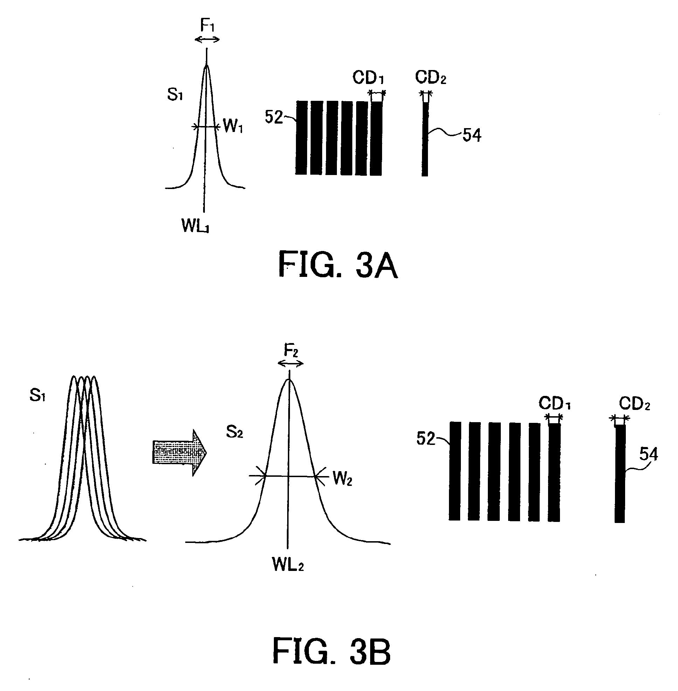

The band-narrowing module 211 implements an output of the laser beam including a wavelength

spectrum $S_1$ that is defined by the center wavelength $WL_1$ and half width $W_1$, as shown on the left side in FIG. 3A. The wavelength selector 211a determines the center wavelength $WL_1$ and the wavelength spectrum $S_1$.

The wavelength spectrum $S_1$ varies within a predetermined variable width $F_1$, but this variable width $F_1$ may possibly be located outside the guaranteed range of the exposure apparatus body 1 or, in particular, the projection lens 13. In this case, for example, when the mask 12 has two types of patterns, *e.g.*, the L&S pattern 52 and isolated pattern 54, which are formed with the same size, the pattern's CD does not become the same, and the $CD_1$ of the element in the L&S pattern 52 and the $CD_2$ of the isolated pattern 54 has a relationship of $CD_1 > CD_2$ as shown on the right side in FIG. 3A.

On the other hand, a wavelength spectrum $S_2$ is wider than the first wavelength spectrum $S_1$ shown on the left side in FIG. 3B. The wavelength spectrum $S_2$ is formed by driving the wavelength selector 211a and oscillating the laser beam having the wavelength spectrum $S_1$ shown in FIG. 3A. The wavelength spectrum $S_2$ has a center wavelength $WL_2$ integrated during the oscillations equal or close to the center wavelength $WL_1$, and varies within a variable width $F_2$ (preferably, $F_2$ is zero) narrower than the variable width $F_1$. Since the variable width $F_2$ is within the guaranteed range of the exposure apparatus body 1, or in particular, the projection lens 13 and the $CD_1$ of the element in the L&S pattern 52 and the $CD_2$ of the isolated pattern 54 are equal to each other or a difference between them is within a permissible range as shown on the right side in FIG. 3B. Alternatively, a width of a wave range which 95 % of laser enters in the wavelength spectrum $S_2$ may be wider than a width of a wave range which 95 % of laser enters in the wavelength spectrum $S_1$. The "width of a wave range which 95 % of laser enters in the first (second) wavelength spectrum" includes a value of a center of the first (second) spectrum (or an average value), and corresponds to $2W1$ (twice as large as $W1$), when Wav is defined as the value of the center (or the average value), and $W1$ is set so that 95 % of the laser is included in a symmetrical range with respect to a wavelength of the value of the center, *i.e.*, between $Wav - W1$ and $Wav + W1$.

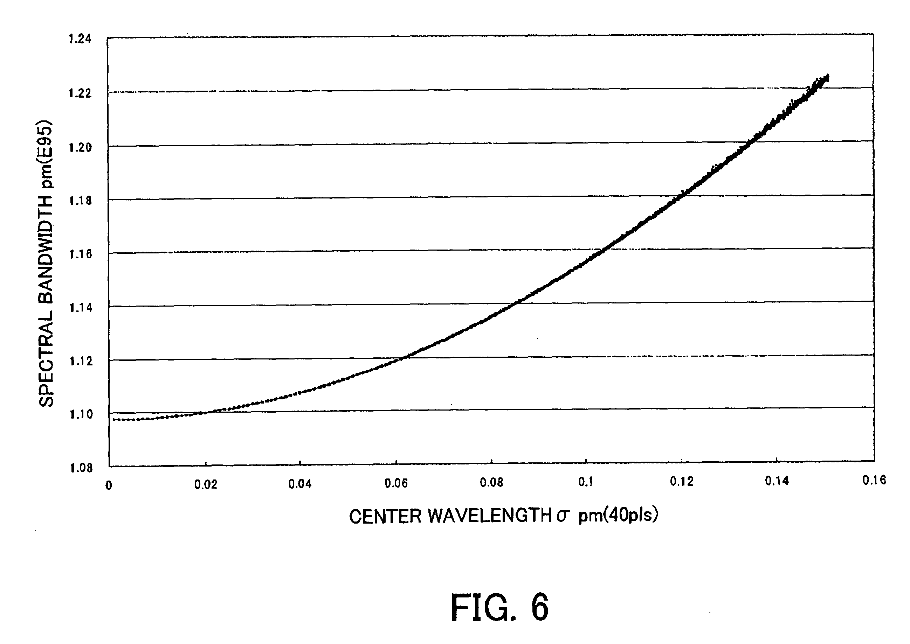

In changing the laser beam shown in FIG. 3A to the integrated laser beam shown in FIG. 3B, the present invention utilizes the fact that the spectral bandwidth $W_1$ of the narrowed wavelength spectrum $S_1$ will fall, even when slightly widened, still within the optimization range of the exposure apparatus body 1. Therefore, according to the instant embodiment, the half width $W_2$ of the wavelength spectrum $S_2$ is within the contrast guaranteed range of the exposure apparatus body 1. A relationship between the center wavelength σ and the spectral width (half width $W_2$) may be set in advance as shown in FIG. 6 for the half width $W_2$ of the wavelength spectrum $S_2$. The graph shown in FIG. 6 is obtained from a simulation using the spectral bandwidth that the projection lens 13 can optimize around the center wavelength σ. An object of the instant embodiment is not to increase the spectral bandwidth from $W_1$ to $W_2$, but to reduce the variable width of the wavelength spectrum from $F_1$ to $F_2$ so as to stabilize the wavelength spectrum.

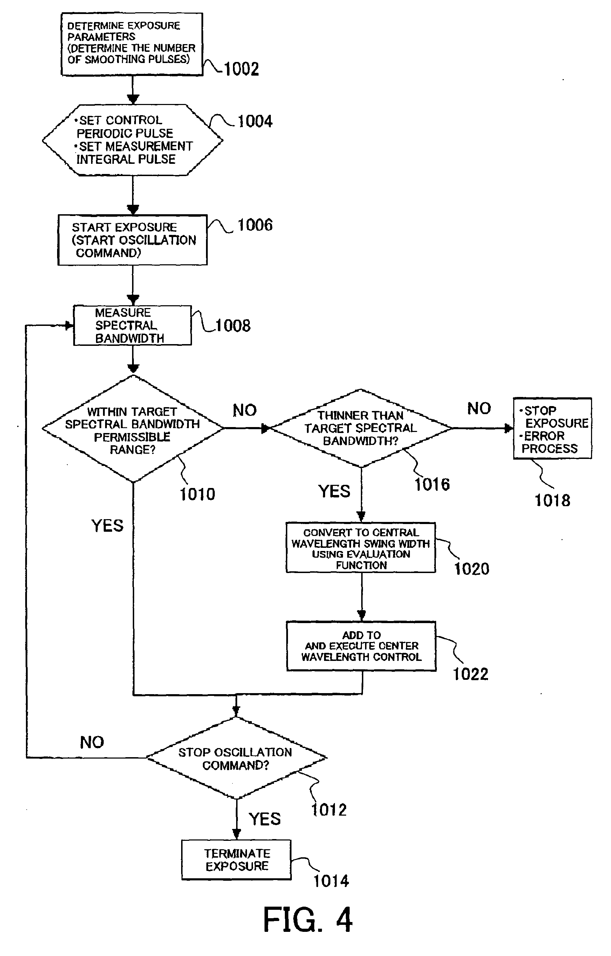

Referring now to FIG. 4, a description will be given of the spectral bandwidth stabilizing method of the present invention. First, the main controller 16 determines the exposure parameters (step 1002), thereby determining the number of smoothing pulses. Next, the main controller 16 sets a control periodic pulse and a measurement integral pulse (step 1004).

Next, the main controller 16 starts the exposure, and sends an oscillation signal to the laser unit 2 based on the measurement result of the barometer 15 shown in FIG. 1 (step 1006). In the step 1006, the beam shaping optical system 3 shapes the light emitted from the laser unit 2 shown in FIG. 1 into a desired shape, the variable ND filter 4 adjusts the light intensity of the laser beam, and the resultant laser beam enters the optical integrator 5. The optical integrator 5 uniformizes the illumination light, and the condenser lens 6 condenses the light onto the masking blade 9 that is located conjugate with the mask 12. The main controller 16 controls the light intensity emitted from the laser unit 2 based on the detection result from the photodetector 8. The masking blade 9 illuminates the mask 12 with an optimal illumination condition via the imaging lens 10 and the mirror 11 after the illumination area is defined. The projection lens (or the projection optical system) 13 projects the light that passes the mask 12 onto the wafer 14 at a predetermined reduction ratio. The exposure apparatus of the step-and-scan manner fixes the light source 2 and the projection optical system 13, and synchronously scans the mask 12 and the wafer 14 to expose the entire shot. The wafer stage (not shown) is stepped to the next shot for a new scan operation. The scan and step are repeated to expose multiple shots on the wafer 14. The exposure apparatus of a step-and-repeat manner exposes while maintaining the mask 12 and the wafer 14 still.

At the main controller 16's command, the wavelength controller 204 measures the spectral bandwidth on the optical monitoring part 208 (step 1008). Next, the wavelength controller 204 determines whether the measured spectral bandwidth is a target spectral bandwidth within the optimization range of the exposure apparatus 100 (step 1010). When the wavelength controller 240 determines that it is within the permissible range (step 1010), the laser main controller 201 continues the emissions until the main controller 16 sends an emission stop command (loop of the steps 1012 and 1008). Thereafter, the main controller 16 terminates the exposure (step 1014).

On the other hand, when the wavelength controller 240 determines that it is not within the permissible range (step 1010), the wavelength controller 240 determines whether the measured spectral bandwidth is thinner than the target spectral bandwidth (step 1016). When the wavelength controller 240 determines that it is not thinner, the main controller 16 stops the exposure and executes the error process since it cannot increase the spectral bandwidth (step 1018).

On the other hand, when the wavelength controller 240 determines that the measured spectral bandwidth is thinner than the target spectral bandwidth (step 1016), the wavelength controller 240 calculates the center wavelength oscillatory width using the evaluation function (step 1020). The wavelength controller 240 executes the center wavelength control in addition to the center wavelength control (step 1022). The procedure moves to the step 1012 after the step 1022.

The exposure apparatus 100 uses the (integrated) laser beam whose variable width is maintained within the permissible range, thus controls resolvable sizes of various patterns, such as a L&S pattern and an isolated pattern, transfers a pattern onto the resist with high precision, and provides high-quality devices (such as a semiconductor device, an LCD device, an image pickup device (such as a CCD), and a thin-film magnetic head).

The present invention is not limited to a case where the exposure apparatus body 1 cannot maintain the variable width $F_1$. Even if it can maintain the variable width $F_1$, the reduced variable width would preferably provide the process with a larger degree of freedom, such as a larger DOF. Thereby, the process becomes so easy that a less expensive wafer can be used.

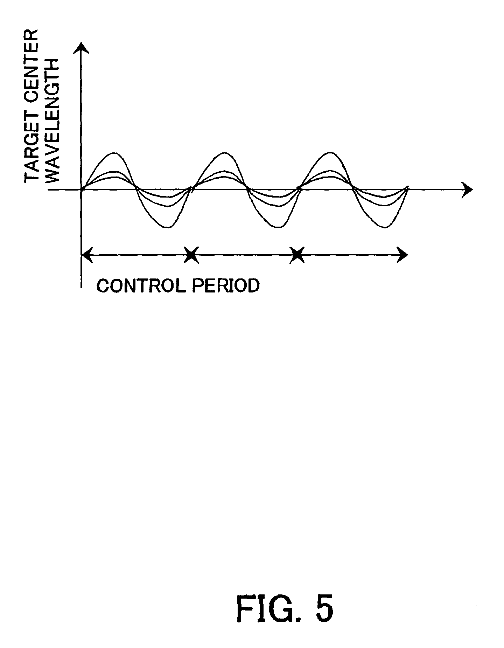

As shown in FIG. 5, the wavelength controller 204 sets the oscillatory period to a control period at which the main controller 16 uses as the timing to projecting the pattern. In FIG. 5, the target center wavelength of the ordinate axis is $WL_2$ and the abscissa axis is the control period determined by the projection lens 13. It is enough that the control period is an n-fold oscillatory period.

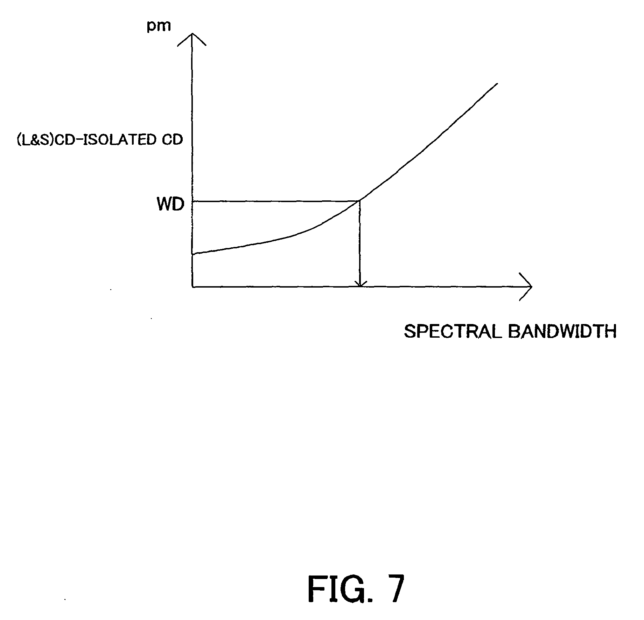

As described above, the wavelength spectrum changing method of the instant embodiment is effective to an approximate equalization between the CD of the L&S pattern 52's element and the CD of the isolated pattern 54, but the present invention is not limited to this embodiment. For example, the wavelength spectrum changing method of the instant embodiment is effective even in intentionally changing their CDs. In creating a difference WD between their CDs, as shown in FIG. 7, the spectral bandwidth corresponding to it can be selected. A necessity to intentionally create a difference between their CDs arises, for example, when an originally intended wafer and resist are not used.

In order to change the wavelength spectrum in an exposure apparatus that exposes a mask pattern onto an object by relatively scanning the pattern and the object as in the instant embodiment, it is preferable that a time period for which the laser beam is irradiated onto one point on the object, such as a wafer, is substantially an integer multiple of the oscillating or driving period of the wavelength selector (the predetermined period). For example, where T1 is a time period for which the laser beam is irradiated onto one point on the object, and T2 is the predetermined time period, the following conditions are preferably met:

[EQUATION 1]

$$(n-0.1)T2 < T1 < (n+0.1)T2 \text{ (n: natural number)}$$

[EQUATION 2]

$$(n-0.01)T2 < T1 < (n+0.01)T2 \text{ (n: natural number)}$$

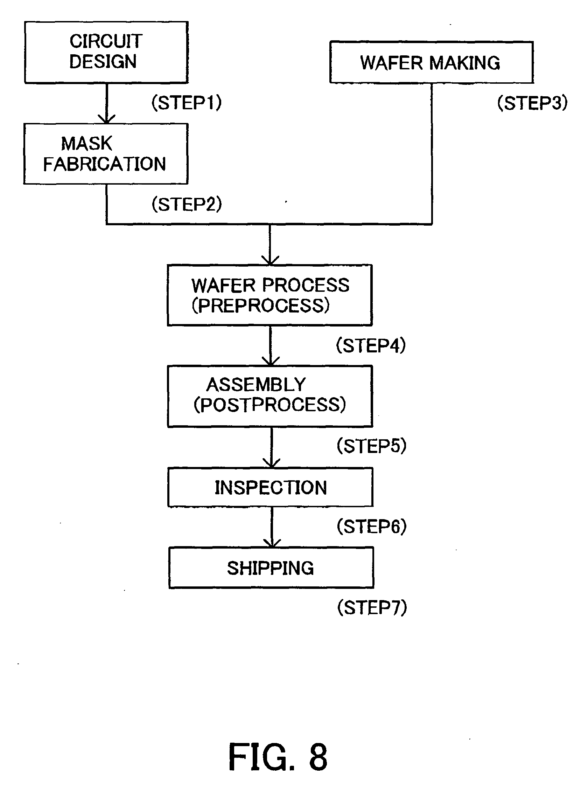

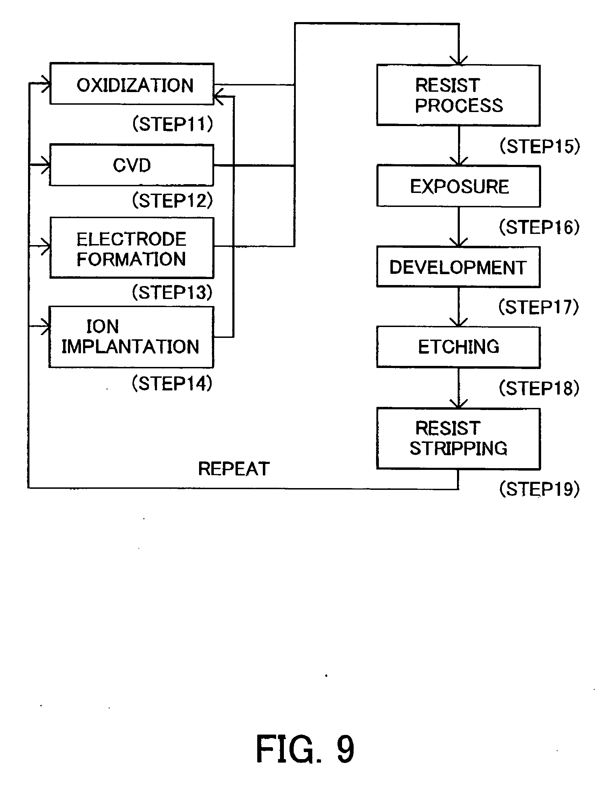

Referring to FIGs. 8 and 9, a description will now be given of an embodiment of a device manufacturing method using the above mentioned exposure apparatus. FIG. 8 is a flowchart for explaining a fabrication of devices (*i.e.*, semiconductor chips such as IC and LSI, LCDs, CCDs, etc.). Here, a description will be given of a fabrication of a semiconductor chip as an example. Step 1 (circuit design) designs a semiconductor device circuit. Step 2 (mask fabrication) forms a mask having a designed circuit pattern. Step 3 (wafer making) manufactures a wafer using materials such as silicon. Step 4 (wafer process), which is referred to as a pretreatment, forms actual circuitry on the wafer through photolithography using the mask and wafer. Step 5 (assembly), which is also referred to as a post-treatment, forms into a semiconductor chip the wafer formed in Step 4 and includes an assembly step (*e.g.*, dicing, bonding), a packaging step (chip sealing), and the like. Step 6 (inspection) performs various tests for the semiconductor device made in Step 5, such as a validity test and a durability test. Through these steps, a semiconductor device is finished and shipped (Step 7).

FIG. 9 is a detailed flowchart of the wafer process in Step 4. Step 11 (oxidation) oxidizes the wafer's surface. Step 12 (CVD) forms an insulating film on the wafer's surface. Step 13 (electrode formation) forms electrodes on the wafer by vapor disposition and the like. Step 14 (ion implantation) implants ions into the wafer. Step 15 (resist process) applies a photosensitive material onto the wafer. Step 16 (exposure) uses the exposure apparatus to expose a circuit pattern on the mask onto the wafer. Step 17 (development) develops the exposed wafer. Step 18 (etching) etches parts other than a developed resist image. Step 19 (resist stripping) removes disused resist after etching. These steps are repeated, and multilayer circuit patterns are formed on the wafer. The device fabrication method of this embodiment may manufacture higher quality devices than the conventional one. Thus, the device fabrication method using the exposure apparatus, and the devices as finished goods also constitute one aspect of the present invention. The present invention covers devices as intermediate and final products. Such devices include semiconductor chips like an LSI and VLSI, CCDs, LCDs, magnetic sensors, thin film magnetic heads, and the like.

The present invention can provide a laser unit, and an exposure method and apparatus using the same, and a device manufacturing method, for the stable spectral bandwidth and the high-quality exposure.

Further, the present invention is not limited to these preferred embodiments, and various variations and modifications may be made without departing from the scope of the present invention.

A laser unit for oscillating a laser of a first wavelength spectrum includes a wavelength selector for determining a first wavelength spectrum, and a drive mechanism for changing the first wavelength spectrum at a predetermined period.

**Claims**

1. A laser unit for oscillating a laser of a first wavelength spectrum, said laser unit comprising:

   a wavelength selector for determining a first wavelength spectrum; and
   a drive mechanism for changing the first wavelength spectrum at a predetermined period.

2. A laser unit according to claim 1, wherein the drive mechanism drives said wavelength selector at the predetermined period.

3. A laser unit according to claim 2, wherein said drive mechanism drives said wavelength selector and a wavelength spectrum that is integrated at the predetermined period of the laser varies at the predetermined period.

4. A laser unit according to claim 2, wherein when a second wavelength spectrum is defined as a wavelength spectrum integrated at the predetermined period of the laser by driving the wavelength selector, a half width of the second wavelength spectrum is wider than a half width of the first wavelength spectrum.

5. A laser unit according to claim 2, wherein when a second wavelength spectrum is defined as a wavelength spectrum integrated at the predetermined period of the laser by driving the wavelength selector, a width of a wave range which 95 % of laser enters in the second wavelength spectrum is wider than a width of a wave range which 95 % of laser enters in the first wavelength spectrum.

6. An exposure apparatus for relatively scanning a pattern on a mask and an object, and for exposing the pattern onto the object, said exposure apparatus comprising:

   an illumination optical system for illuminating the pattern using a laser beam from a laser unit according to claim 1.

7. An exposure apparatus according to claim 6, wherein a time period for which the laser beam is irradiated onto one point on the object is substantially an integer multiple of the predetermined period.

8. An exposure apparatus according to claim 6, wherein $(n-0.1)T2 < T1 < (n+0.1)T2$ is met, where n is an integer, T1 is a time period for which the laser beam is irradiated onto one point on the object, and T2 is the predetermined time period.

9. A laser unit for outputting a laser beam of a first wavelength spectrum that includes a center wavelength and varies within a first variable width, said laser unit comprising:

   a wavelength selector for determining the center wavelength and the first wavelength spectrum; and
   a driving unit for driving said wavelength selector and oscillating the laser beam, the laser beam integrated during oscillations includes a center wavelength that is equal or close to the center wavelength of the first wavelength spectrum, and a second wavelength spectrum that varies within a second variable width smaller than the first variable width and is wider than the first wavelength spectrum.

10. A laser unit according to claim 9, wherein the driving unit includes a piezoelectric element.

11. An exposure apparatus comprising:

   a laser unit according to claim 9; and
   a projection optical system for projecting a pattern on a mask onto an object using the laser beam emitted from the laser unit as exposure light.

12. An exposure method for projecting a pattern on a mask onto an object to be exposed, by using a laser beam as exposure light, the laser beam including a center wavelength and a first spectrum and varies within a first variable width, said exposure method comprising the steps of:

   oscillating the laser beam so that the laser beam integrated during oscillations includes a center wavelength that is equal or close to the center wavelength of the first variable width, and a second wavelength spectrum that varies within a second variable width smaller than the first variable width and is wider than the first wavelength spectrum; and
controlling a period of said oscillating step to a period of a projection of the pattern onto the object.

13. An exposure apparatus according to claim 12, wherein said exposure method uses an exposure apparatus for projecting the pattern onto the object, and for optimizing the second wavelength spectrum around the center wavelength.

14. An exposure apparatus according to claim 12, wherein said exposure method uses an exposure apparatus for projecting the pattern onto the object, and the pattern includes different types of first and second patterns that have the same size and are formed on the mask,
wherein the exposure apparatus resolves the first and second patterns when using an integral laser beam having the second variable width, but resolves only one of the first and second patterns when using a laser beam having the first variable width.

15. An exposure method for projecting a pattern on a mask onto an object via a projection optical system using exposure light, and for controlling a resolved size of the pattern projected onto the object, said exposure method comprising the steps of:

controlling an effective spectral bandwidth of a laser beam that includes a center wavelength and a first wavelength spectrum, and varies within a first variable width.

16. An exposure method according to claim 15, wherein said controlling step includes:

oscillating the laser beam so that the laser beam integrated during oscillations includes a center wavelength that is equal or close to the center wavelength of the first wavelength spectrum, and a second wavelength spectrum that varies within a second variable width smaller than the first variable width and is wider than the first wavelength spectrum; and
calculating the second wavelength spectrum from a performance of the projection optical system.

17. An exposure method according to claim 16, wherein the pattern includes different types of first and second patterns that have the same size and are formed on the mask,

wherein the performance includes a relationship between a difference of a critical dimension of the first and second patterns, and a spectral bandwidth with respect to the center wavelength.

18. An exposure method according to claim 16, wherein the pattern includes different types of first and second patterns that have the same size and are formed on the mask,
wherein said controlling step changes resolvable critical dimensions between the first and second patterns projected onto the object.

19. A device manufacturing method comprising the steps of:

exposing an object using an exposure apparatus according to claim 6; and
developing an object that has been exposed.

20. A device manufacturing method comprising the steps of:

exposing an object using an exposure apparatus according to claim 11; and
developing an object that has been exposed.

FIG. 1

TO 16

# FIG. 2

## FIG. 3A

## FIG. 3B

FIG. 4

FIG. 5

FIG. 6

EP 1 548 501 A2

pm

(L&S)CD-ISOLATED CD

WD

SPECTRAL BANDWIDTH

# FIG. 7

CIRCUIT
DESIGN

(STEP1)

WAFER MAKING

(STEP3)

MASK
FABRICATION

(STEP2)

WAFER PROCESS
(PREPROCESS)

(STEP4)

ASSEMBLY
(POSTPROCESS)

(STEP5)

INSPECTION

(STEP6)

SHIPPING

(STEP7)

FIG. 8

OXIDIZATION

(STEP11)

CVD

(STEP12)

ELECTRODE
FORMATION

(STEP13)

ION
IMPLANTATION

(STEP14)

RESIST
PROCESS

(STEP15)

EXPOSURE

(STEP16)

DEVELOPMENT

(STEP17)

ETCHING

(STEP18)

RESIST
STRIPPING

(STEP19)

REPEAT

# FIG. 9